# EUROPEAN PATENT APPLICATION

(11) **EP 0 779 743 A2**
(43) Date of publication of application: **18.06.1997**
(21) Application number: 96309065.9
(22) Date of filing: 12.12.1996
(51) Int. Cl.: H04N 7/36

(54) **Apparatus for half-pixel image motion compensation**

(30) Priority: 13.12.1995 KR 9549398
(71) Applicant: Samsung Electronics Co., Ltd., Suwon City, Kyungki-do (KR)
(72) Inventor: Kim, Je-Ik, Kangbuk-gu, Seoul (KR)
(74) Representative: Chugg, David John

(57) **Abstract**

A half-pixel processing apparatus of a macroblock for motion compensation of a moving image is provided in which NxN pixel data selected for the motion compensation of the moving image, is divided into a predetermined unit and half-pixel processed. The half-pixel processing apparatus includes a first unit (31, 32) for summing successive pixel data constituting the N kinds of pixel data and pixel data horizontally adjacent to the successive pixel data constituting the N kinds of pixel data according to a horizontal half-pixel processing signal which is input from an external source, a pipeline unit (33-36) for sequentially storing and outputting the data applied from the first unit (31, 32), a second unit (37, 38) for summing the pixel data output from the pipeline unit (33-36) and pixel data vertically adjacent to the pixel data output from the pipeline unit (33-36) according to a vertical half-pixel processing signal which is input from an external source, a data processor (39) for half-pixel processing the data applied from the second unit (37, 38) and having the data pass through as it is, according to the horizontal half-pixel processing signal and the vertical half-pixel processing signal, flip-flops (41-44) for dividing th data applied from the data processor (39) according to clock and storing the divided data respectively, and multiplexers (45, 46) for selecting and outputting data necessary for motion compensation among the data output from the flip-flops (41-44).

## Description

The present invention relates to apparatus for motion compensation of a moving image, and more particularly, to a half-pixel processing apparatus of a macroblock for motion compensation of a bidirectionally-predictive coded picture (B-picture) which performs a motion compensation operation at both sides of a front image and a rear image.

Generalised methods for encoding a motion image signal into digital data and processing the same have been proposed in the prior art. Also, since the amount of data increases greatly when a moving image signal is encoded into digital data, compression technology for compressing motion image data has been developed in order to remove redundant data of the motion image signal to address this increase in data.

Particularly, to effectively compress motion image data, three types of pictures such as an intra-coded picture (I-picture), a predictive coded picture (P-picture) and a B-picture are defined in the Moving Picture Experts Group (MPEG) standard. The I-picture is defined as being encoded without reference to the other pictures, the P-picture is defined as being encoded in order to use a motion compensated prediction from the I-picture or another P-picture which is temporally earlier than the former P-picture, and the B-picture is defined as being most effectively encoded with reference to the pictures which are both temporally earlier or later than the B-picture.

The MPEG-2 adopts a half-pixel processing method for a further accurate motion compensation operation. The half-pixel processing method obtains interpixel data by averaging data of horizontally and/or vertically neighbouring pixels. A conventional half-pixel processing method reads 16 pixels per macroblock at a time for horizontally processing a half-pixel, to average horizontally 16 neighbouring pixels, and do the same for vertically processing a half-pixel, to average between a pixel of a previous line and the vertically neighbouring pixels. Particularly, since screens of pictures which are located temporally before or after the B-picture are required to perform a motion compensation thereof, a memory for separately storing data of the pixels of a previous line is required to process a half-pixel of a macroblock. Also, it is impossible to successively output data.

With a view to solving or reducing the above problem, it is an aim of embodiments of the present invention to provide a half-pixel processing apparatus of a macroblock for motion compensation of a B-picture, in which pixel data necessary for a half-pixel processing is stored and at the same time sequentially output via a pipeline including latches, and data which has passed through the pipeline and is half-pixel processed is successively selected and output for motion compensation.

According to a first aspect of the present invention, there is provided a half-pixel processing apparatus of a macroblock for motion compensation of a moving image in which NxN pixel data selected for the motion compensation of the moving image, is divided into a predetermined unit and half-pixel processed, the half-pixel processing apparatus comprising:
first means for summing successive pixel data constituting the N kinds of pixel data and pixel data horizontally adjacent to the successive pixel data constituting the N kinds of pixel data according to a horizontal half-pixel processing signal which is input from an external source;
pipeline means for sequentially storing and outputting the data applied from the first means;
second means for summing the pixel data output from the pipeline means and pixel data vertically adjacent to the pixel data output from the pipeline means according to a vertical half-pixel processing signal which is input from an external source;
data processing means for half-pixel processing the data applied from the second means and having the data pass through as it is, according to the horizontal half-pixel processing signal and the vertical half-pixel processing signal;
flip-flop means for dividing the data applied from the data processing means according to clock and storing the divided data respectively; and
multiplexing means for selecting and outputting data necessary for motion compensation among the data output from the flip-flop means.

Preferably, said pipeline means comprises a plurality of latches in which a first latch of said pipeline means stores data applied from said first means and the last latch of said pipeline means outputs data applied from said upper latch to said second means.

Said first means may comprise: a first AND gate for receiving the horizontal half-pixel processing signal and the successive pixel data constituting the N kinds of the pixel data, and performing a logical multiplication; and a first adder for adding the data applied from said first AND gate and the pixel data horizontally adjacent to the successive pixel data.

Said second means may comprise: a second AND gate for receiving the vertical half-pixel processing signal and the pixel data vertically adjacent to the pixel data output from said pipeline means, and performing the logical multiplication; and a second adder for adding the pixel data applied from said second AND gate and said pipeline means.

Preferably, said first and second means include an input carry according to a respectively horizontal and vertical half-pixel processing signal, and wherein said data processing means rounds the input data using said carry in order to obtain divide-by-two or divide-by-four data.

Said flip-flop means may divide the data input from said data processing means into two parts and stores the two parts.

According to a second aspect of the invention there is provided a half-pixel processing apparatus for motion compensation of a B-picture, the apparatus being characterised in that pixel data is stored and, at the same time, processed by means of a pipeline comprising a plurality of serially connected latches, and data which has already passed through the pipeline is successively selected and output.

The apparatus may include any one or more features from the accompanying description, claims, abstract or drawings, in any combination.

For a better understanding of the invention, and to show how embodiments of the same may be carried into effect, reference will now be made, by way of example, to the accompanying diagrammatic drawings, in which:
Figure 1 is a conceptual diagram for explaining a 17-pixel by 17-line for half-pixel processing;
Figures 2A and 2B are conceptual diagrams respectively showing a 17-pixel by 17-line for half-pixel processing in which Figure 2A shows a front picture and Figure 2B shows a rear picture;
Figure 3 is a block diagram of a half-pixel processing apparatus of a macroblock according to a preferred embodiment of the present invention; and
Figures 4A-4G are timing diagrams of the flip-flop means in the Figure 3 apparatus.

A preferred embodiment of the present invention will be described in detail with reference to the accompanying drawings.

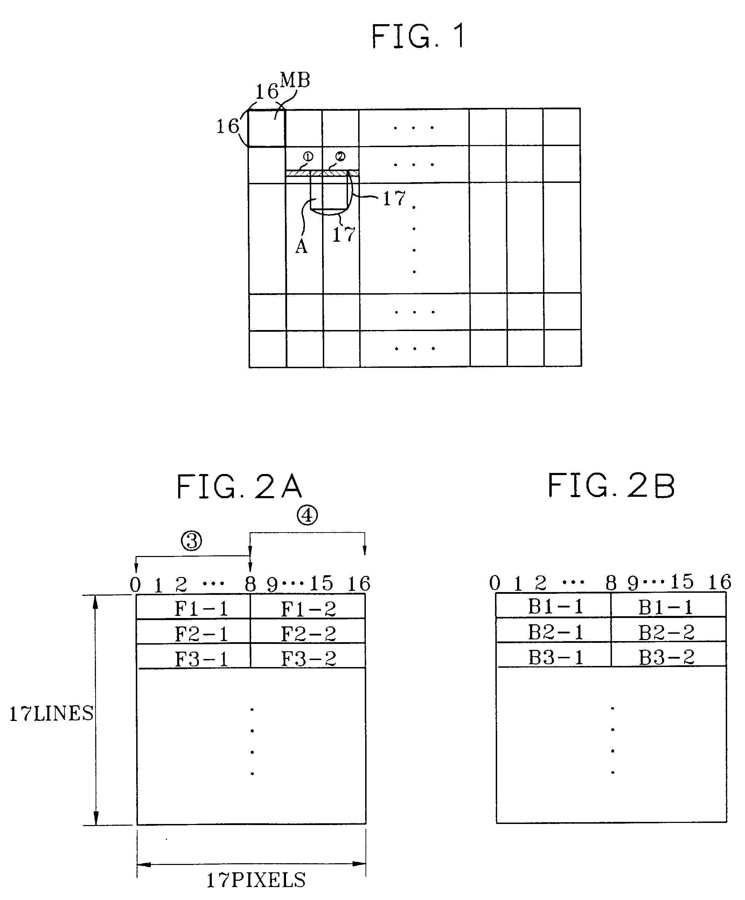

Referring to Figure 1 for explaining a 17-pixel by 17-line for half-pixel processing, a macroblock which is a general motion compensation unit is constituted by a 16-pixel by 16-line unit with respect to a luminance signal in the MPEG standard. However, 17 pixels are required for horizontal half-pixel processing and data of 17 lines are required for vertical half-pixel processing. That is, to obtain 17x17 interpixel data as shown in Figure 1 at the time of half-pixel processing a macroblock, 17 pixels in the horizontal direction and data of 17 lines in the vertical direction should be selected.

Figures 2A and 2B are conceptual diagrams respectively showing a 17-pixel by 17-line for half-pixel processing in which Figures 2A shows a front picture and Figures 2B shows a rear picture. Referring to Figures 2A and 2B, the half-pixel processing apparatus according to the present invention does not perform a half-pixel processing operation in units of 16 pixels but does so in units of 8 pixels, as a half-pixel processing unit of a macroblock. That is, embodiments of the present invention do not adopt a conventional method whereby all 17 pixels are read from a first line of a front picture, and then pixel data of 0th pixel through 16th pixel and pixel data of 1st pixel through 17th pixel is averaged out, to obtain half-pixel processed data. Instead, embodiments of the present invention read 9 kinds of pixel data of 0th through 8th pixel, and averages the 0th through 7th pixel data and the 1st through 8th pixel data to output 8 kinds of half-pixel processed pixel data. Thereafter, 9 kinds of remaining pixel data of 8th through 16th pixel are read, and the read pixel data is averaged to output 8 kinds of half-pixel processed pixel data. Using such a method, the half-pixel processing apparatus can perform a half-pixel processing operation with respect to signals of U and V components whose basic motion compensation unit is 8x8 as well as a Y signal.

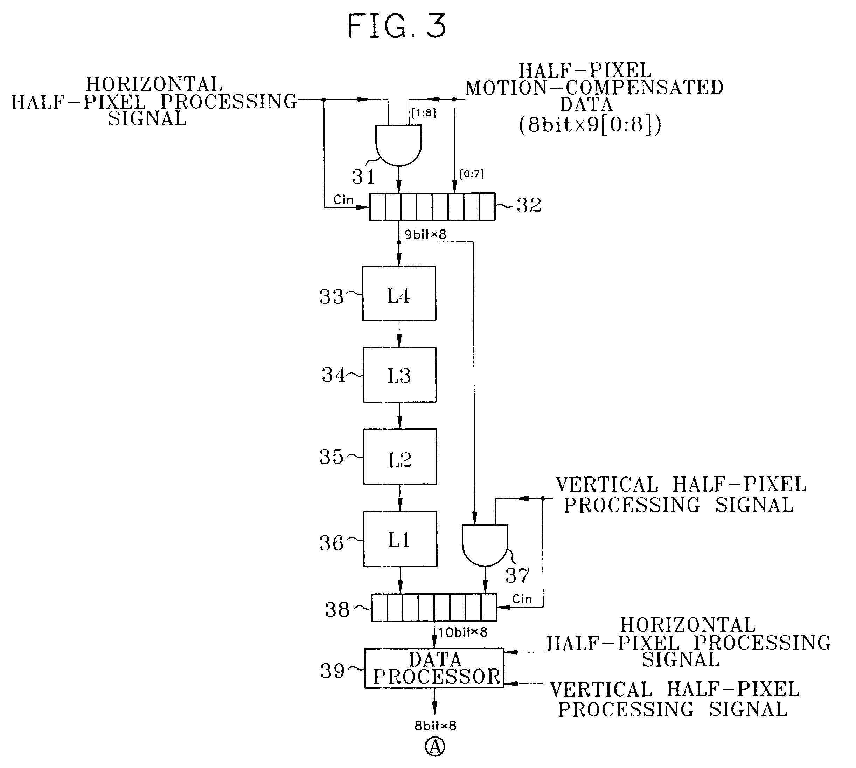

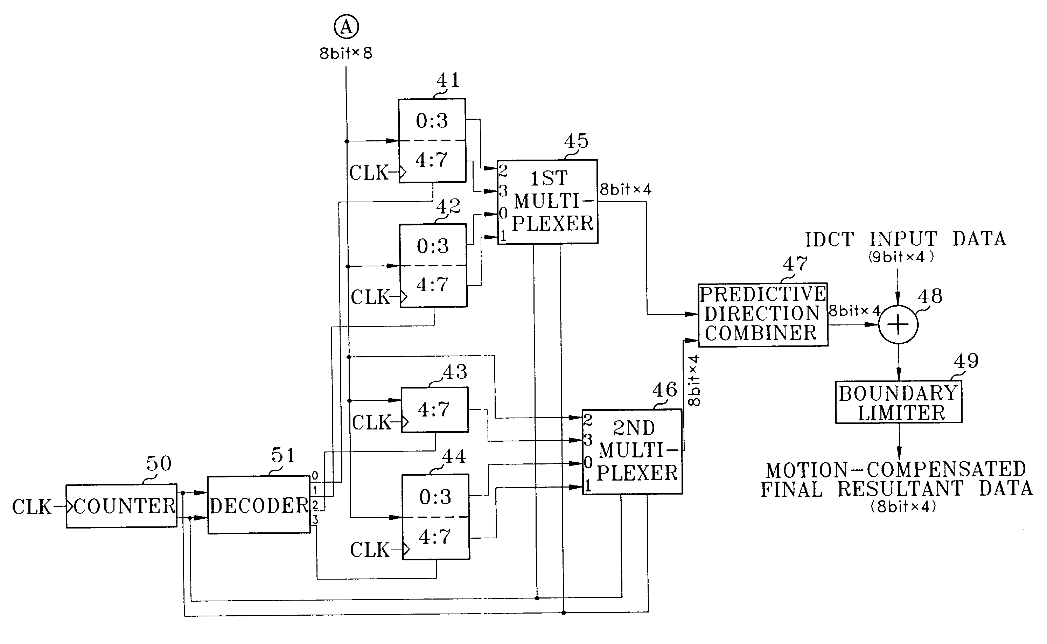

Figure 3 is a block diagram of a half-pixel processing apparatus of a macroblock according to a preferred embodiment of the present invention. First, the Figure 3 half-pixel processing apparatus receives data (F1-1) of 9 pixels [0:8] of a front picture for half-pixel processing. Data of lower 8 pixels [0:7] among the data of the 9 pixels [0:8] of the front picture is applied to a first adder 32, and data of upper 8 pixels [1:8] is applied to a first AND gate 31. When a horizontal half-pixel processing signal is applied from an external source to the first AND gate 31, a logic signal "0" is applied for non-horizontal half-pixel processing, and a logic signal "1" is applied on the contrary, that is, for horizontal half-pixel processing. When a logic signal "0" is applied thereto for the non-horizontal half-pixel processing, the output of the first AND gate 31 is "0", and thus only [0:7] data is input to the first adder 32. In the case for horizontal half-pixel processing, [1:8] data is output to the first adder 32 from the first AND gate 31, and a carry Cin of "1" is applied to the first adder 32. The first adder 32 adds the input [0:7] data and the input [1:8] data including the carry of "1" and outputs 8 kinds of data of 9 bits in which one bit is increased, to a fourth latch (L4) 33. The 8 kinds of data of 9 bits in which one bit is increased is also output to a second AND gate 37, which is for horizontal half-pixel processing of data output from a first latch (L1) 36 after passing through four latches 33-36.

The Figure 3 half-pixel processing apparatus receives data (F1-2) of the remaining 9 pixels [8:16] of the first line of the front picture for next clock. The [8:16] data is processed as in the [0:7] data. When the processed result is applied to the fourth latch 33, the data of F1-1 stored in the fourth latch 33 is applied to a third latch 34.

In the following clock, [0:8] data B1-1 of the first line of the rear picture is applied and processed likewise. When the processed result is applied to the fourth latch 33, the data of F1-2 stored in the fourth latch 33 is applied to the third latch 34 and at the same time the data of F1-1 stored in the third latch 34 is applied to a second (L2) latch 35.

In the following clock, [8:16] data B1-2 of the first line of the rear picture is applied and processed likewise. When the processed result is applied to the fourth latch 33, the data of B1-1 stored in the fourth latch 33 is applied to the third latch 34, and at the same time the data of F1-2 stored in the third latch 34 is applied to the second latch 35, and at the same time the data of F1-1 stored in the second latch 35 is applied to the first latch (L1) 36.

In the following clock, [0:8] data F2-1 of the second line of the front picture is applied and processed likewise. When the processed result is applied to the fourth latch 33, the data of B1-2 stored in the fourth latch 33 is applied to the third latch 34, and at the same time the data of B1-1 stored in the third latch 34 is applied to the second latch 35, and at the same time the data of F1-2 stored in the second latch 35 is applied to the first latch 36, and at the same time the data of F1-1 stored in the first latch 36 is applied to the second adder 38.

The above four latches 33-36 constitutes a pipeline structure.

Meanwhile, the F2-1 data processed according to the presence of the horizontally half-pixel processing is applied to the fourth latch 33 and at the same time to the second AND gate 37. The second AND gate 37 receives a vertical half-pixel processing signal and outputs the data as it is or outputs "0". That is, the second AND gate 37 receives a vertical half-pixel processing signal of "1" for vertical half-pixel processing and outputs the processed F2-1 data to the second adder 38 as it is. In this case, a carry Cin for the second adder 38 is "1". The second AND gate 37 receives a vertical half-pixel processing signal of "0" for non-vertical half-pixel processing and outputs a logic signal "0".

Thus, in the case for the vertical half-pixel processing, the second adder 38 adds the F1-1 data input from the first latch 36 and the F2-1 data output from the second AND gate 37, and the carry Cin of "1". Meanwhile, in the case for non-vertical half-pixel processing, the output of the second AND gate 37 is "0" and the carry Cin is "0", the F1-1 data input from the first latch 36 is output as it is.

The data output from the second adder 38 outputs 10 bits by 8 data according to the presence of the horizontal or vertical half-pixel processing at the maximum. In the case when a half-pixel processing operation is performed only horizontally or only vertically, 8 kinds of data of 9 bits is output. In the case when a half-pixel processing operation is performed horizontally and vertically, 8 kinds of data of 10 bits is output. In the case when such a half-pixel processing operation is not performed, 8 kinds of data of 8 bits is output.

A data processor 39 determines whether the input data is divided into 2 or 4 or is output as it is, according to a vertical half-pixel processing signal and a horizontal half-pixel processing signal. That is, the input 8 kinds of data of 9 bits is divided into 2 in the case for only vertically or horizontally half-pixel processing, the input 8 kinds of data of 10 bits is divided into 4 in the case for the vertically and horizontally half-pixel processing, and the input data is output as it is in the case when such a half-pixel processing operation is not performed. In this case, a round operation can be easily performed using the carry input by the horizontally half-pixel processing signal or the vertically half-pixel processing signal.

In all cases, the data output from the data processor 39 is 8 kinds of data of 8 bits.

The data output from the data processor 39 is applied to the four flip-flops 41-44. The four flip-flops 41-44 receive an enable signal, respectively. The enable signals of the four flip-flops 41-44 are generated by a 2-bit counter 50 and a decoder 51. The 2-bit counter 50 outputs a 2-bit count value of 0 through 3 according to input clock, and the decoder 51 generates the enable signals of 0 through 3 for the respective flip-flop 41-44, according to the count value which is input on a 2-bit basis.

Each flip-flop 41, 42, 43 or 44 divides the 8-byte data into 2 and stores and outputs the 4-byte data. Particularly, the third flip-flop 43 stores only the lower 4 bytes.

A first multiplexer 45 and a second multiplexer 46 select data using the four flip-flops 41-44 and output the selected data to a predictive direction combiner 47.

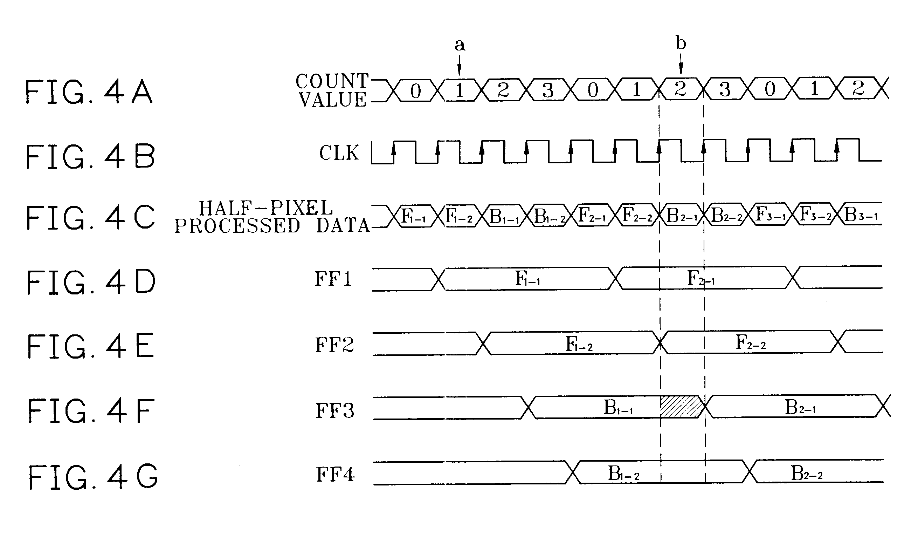

Figures 4A-4G are timing diagrams of the flip-flops in the Figure 3 apparatus. Figure 4A shows a count value of the 2-bit counter 50, Figure 4B shows a clock signal, and Figure 4C shows the half-pixel processed data output from the data processor 39.

As shown in Figures 4A through 4G, when a count value is "0", the first flip-flop 41 is enabled at the rising edge of the following clock and the half-pixel processed 9-byte F1-1 data is divided into upper 4-byte data [0:3] and lower 4-byte data [4:7] to store the result.

When a counter value is "1", the second flip-flop 42 is enabled at the rising edge of the following clock, and the half-pixel processed 8-byte F1-2 data is stored.

when a count value is "2", the third flip-flop 43 is enabled at the rising edge of the following clock, and the lower 4-byte [4:7] among the half-pixel processed 8-byte B1-1 data is stored. At the same time, the first multiplexer 45 selects the data of [0:3] of the F1-1 data stored in the first flip-flop 41 and the second multiplexer 46 selects the data of the non-stored upper 4-byte data [0:3] among the B1-1 data of the half-pixel processed data. The selected data is output to the predictive direction combiner 47.

When a count value is "3", the fourth flip-flop 44 is enabled at the rising edge of the following clock, and the half-pixel processed B1-2 data is stored. At the same time, the first multiplexer 45 selects the data of [4:7] of the F1-1 data stored in the first flip-flop 41 and the second multiplexer 46 selects the data of [4:7] of the B1-1 stored in the third flip-flop 43. The selected data is output to the predictive direction combiner 47.

Using the count value of 0 through 3 output from the decoder 51 shown in Figure 3, it can be seen which flip-flop will be enabled according to the count values thereof. Also, using the count values such as 2, 3, 0 and 1 in the first and second multiplexers 45 and 46, it can be seen which flip-flop will be selected according to the count values thereof.

The predictive direction combiner 47 receives the 4-byte data of the front picture selected by the first multiplexer 45 and the 4-byte data of the rear picture selected by the second multiplexer 46 and averages the received data and outputs the result to a summator 48.

The summator 48 receives inverse discrete cosine transform (IDCT) data and sums the received IDCT data with the data output from the predictive direction combiner 47 and outputs the result to a boundary limiter 49.

The boundary limiter 49 limits the size of the data in order to output final 4-byte data which has been motion-compensated.

According to the apparatus according to the embodiment of the present invention described, the 4-byte data is output per each clock by the first and second multiplexers 45 and 46. Thus, the data is successively output. Also, if a half-pixel processing unit is 8 bytes, the present invention can be used for processing the signals of the U and V components as well as the Y signal.

While only certain embodiments of the invention have been specifically described herein, it will be apparent that numerous modifications may be made thereto without departing from the scope of the invention.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A half-pixel processing apparatus of a macroblock for motion compensation of a moving image in which NxN pixel data selected for the motion compensation of the moving image, is divided into a predetermined unit and half-pixel processed, the half-pixel processing apparatus comprising:
first means (31, 32) for summing successive pixel data constituting said N kinds of pixel data and pixel data horizontally adjacent to said successive pixel data constituting said N kinds of pixel data according to a horizontal half-pixel processing signal which is input from an external source;
pipeline means (33-36) for sequentially storing and outputting the data applied from said first means (31, 32);
second means (37, 38) for summing the pixel data output from said pipeline means (33-36) and pixel data vertically adjacent to the pixel data output from said pipeline means (33-36) according to a vertical half-pixel processing signal which is input from an external source;
data processing means (39) for half-pixel processing the data applied from said second means (37, 38) and having the data pass through as it is, according to the horizontal half-pixel processing signal and the vertical half-pixel processing signal;
flip-flop means (41-44) for dividing the data applied from said data processing means (39) according to clock and storing the divided data respectively; and
multiplexing means (45-46) for selecting and outputting data necessary for motion compensation among the data output from said flip-flop means (41-44).

2. A half-pixel processing apparatus of a macroblock according to claim 1, wherein said pipeline means (33-36) comprises a plurality of latches in which a first latch (33) of said pipeline means stores data applied from said first means (32) and the last latch (36) of said pipeline means outputs data applied from said upper latch to said second means (38).

3. A half-pixel processing apparatus of a macroblock according to claim 1 or 2, wherein said first means comprises:
a first AND gate (31) for receiving the horizontal half-pixel processing signal and the successive pixel data constituting the N kinds of the pixel data, and performing a logical multiplication; and
a first adder (32) for adding the data applied from said first AND gate (31) and the pixel data horizontally adjacent to the successive pixel data.

4. A half-pixel processing apparatus of a macroblock according to claim 1, 2 or 3, wherein said second means (37, 38) comprises:
a second AND gate (37) for receiving the vertical half-pixel processing signal and the pixel data vertically adjacent to the pixel data output from said pipeline means (33-36), and performing the logical multiplication; and
a second adder (38) for adding the pixel data applied from said second AND gate (37) and said pipeline means (33-36).

5. A half-pixel processing apparatus of a macroblock according to claim 1, 2, 3 or 4 wherein said first and second means (31, 32; 37, 38) include an input carry according to a respectively horizontal and vertical half-pixel processing signal, and wherein said data processing means (39) rounds the input data using said carry in order to obtain divide-by-two or divide-by-four data.

6. A half-pixel processing apparatus of a macroblock according to claim 1, 2, 3, 4 or 5 wherein said flip-flop means (41-44) divides the data input from said data processing means (39) into two parts and stores the two parts.

7. A half-pixel processing apparatus for motion compensation of a B-picture, the apparatus being characterised in that pixel data is stored and, at the same time, processed by means of a pipeline comprising a plurality of serially connected latches (33-36), and data which has already passed through the pipeline is successively selected and output.

8. Apparatus according to claim 7, further comprising any one or more features from the accompanying description, claims, abstract or drawings, in any combination.
